(19) Europäisches Patentamt / European Patent Office / Office européen des brevets

(11) **EP 4 632 409 A1**

(12) **EUROPEAN PATENT APPLICATION**
published in accordance with Art. 153(4) EPC

(43) Date of publication:
**15.10.2025 Bulletin 2025/42**

(21) Application number: **23900426.0**

(22) Date of filing: **16.11.2023**

(51) International Patent Classification (IPC):
**G01R 31/392** (2019.01)   **G01R 31/367** (2019.01)
**G01R 31/382** (2019.01)   **G01R 31/385** (2019.01)
**G01R 31/387** (2019.01)   **G01R 31/396** (2019.01)
**H01M 10/48** (2006.01)    **H02J 7/00** (2006.01)

(52) Cooperative Patent Classification (CPC):
**G01R 31/367; G01R 31/382; G01R 31/385;
G01R 31/387; G01R 31/392; G01R 31/396;
H01M 10/48; H02J 7/00**

(86) International application number:
**PCT/JP2023/041323**

(87) International publication number:
**WO 2024/122305 (13.06.2024 Gazette 2024/24)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **05.12.2022 JP 2022194289**

(71) Applicant: **Panasonic Intellectual Property
Management Co., Ltd.
Kadoma-shi, Osaka 571-0057 (JP)**

(72) Inventor: **NISHIKAWA Shinya
Kadoma-shi, Osaka 571-0057 (JP)**

(74) Representative: **Novagraaf International SA
Chemin de l'Echo 3
1213 Onex, Geneva (CH)**

(54) **BATTERY ANALYSIS SYSTEM, BATTERY ANALYSIS METHOD, BATTERY ANALYSIS PROGRAM, AND STORAGE MEDIUM CONTAINING BATTERY ANALYSIS PROGRAM**

(57) A minimum SOH calculator calculates a minimum SOH among SOHs of a plurality of cells or a plurality of cell blocks included in an assembled battery system based on battery data. A SOC difference calculator calculates an SOC difference based on a maximum SOC and a minimum SOC among SOCs of those cells or blocks and the minimum SOH of the assembled battery system, based on the battery data. A statistical processor performs steps of: extracting at least one change point from a sample group of SOC differences; calculating a regression model of the SOC difference for each of intervals divided by the change point; calculating a regression model of the minimum SOH using the sample group of minimum SOHs; and calculating a regression model of an SOH of the assembled battery system by combining the regression model of the minimum SOH and the interval-based the SOC difference.

EP 4 632 409 A1

# FIG. 1

## Description

### TECHNICAL FIELD

The present disclosure relates to a battery analysis system, a battery analysis method, and a battery analysis program for estimating a state of health (SOH) of an assembled battery system.

### BACKGROUND ART

An assembled battery system with many battery cells connected in series and parallel is required to estimate not only an SOH of each cell but also the SOH of the entire assembled battery system (referred to below as a system SOH as appropriate) and predict the system SOH. To estimate and predict the system SOH, an SOH difference or a state of charge (SOC) difference among cell blocks connected in series needs to be considered. The cell blocks herein are each defined as including a plurality of cells connected in parallel.

The SOC difference among the cell blocks is generated by a difference in leak current among the cell blocks. Specifically, the SOC difference among the cell blocks changes depending on difference in power consumption among the cell blocks, occurrence of a micro-short circuit inside a cell, equalization processing, or the like. The difference in power consumption and the occurrence of a micro-short circuit are factors of enlargement of the SOC difference among the cell blocks, and the equalization processing is a factor of reduction of the SOC difference among the cell blocks.

PTL 1 discloses a method for estimating a system SOH by using a capacity difference from a maximum SOC at the time of completion of discharge as an SOC difference. However, variation in SOH among cells is not taken into consideration, so that a large variation in SOH may cause deterioration in estimation accuracy of the system SOH. PTL 2 discloses a method for detecting a sudden degradation point of a cell to predict an SOH by linear regression after the sudden degradation. However, a variation of the SOC among cells for systemization is not taken into consideration. When the system SOH is estimated with a large variation of the SOC, estimation accuracy may deteriorate.

Citation List

Patent Literature

PTL 1: Unexamined Japanese Patent Publication No. 2019-113414
PTL 2: International Publication No. WO 17/098686

### SUMMARY OF THE INVENTION

The present disclosure has been made in view of the above circumstance, and an object thereof is to provide a technique for estimating an SOH of an assembled battery system with high accuracy.

To solve the above problem, a battery analysis system according to an aspect of the present disclosure includes: a data acquisition unit configured to acquire battery data including at least voltage and current of each of a plurality of cells connected in series and included in an assembled battery system, or of each of a plurality of cell blocks each including a plurality of cells connected in parallel, the plurality of cell blocks being connected in series and included in the assembled battery system; a minimum SOH calculator configured to calculate a minimum SOH among SOHs of the plurality of cells or the plurality of cell blocks included in the assembled battery system based on the battery data; an SOC difference calculator configured to calculate an SOC difference based on the battery data, the SOC difference being calculated based on a maximum SOC and a minimum SOC among SOCs of the plurality of cells or the plurality of cell blocks and the minimum SOH of the assembled battery system, based on at least the voltage of each of the plurality of cells or each of the plurality of cell blocks included in the assembled battery system; and a statistical processor configured to perform steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of the assembled battery system based on the regression model of the minimum SOH and the regression model of the SOC difference for each of the intervals.

Any combinations of configuration elements described above and expressions of the present disclosure that are converted in terms of devices, systems, methods, computer programs, recording media, and the like are also effective as aspects of the present disclosure.

The present disclosure enables estimating an SOH of an assembled battery system with high accuracy.

## BRIEF DESCRIPTION OF THE DRAWINGS

Fig. 1 is a diagram for illustrating a battery analysis system according to an exemplary embodiment.

Fig. 2A is a diagram illustrating a configuration example of an assembled battery system including a plurality of cells connected in series.

Fig. 2B is a diagram illustrating a configuration example of an assembled battery system including a plurality of cell blocks connected in series, and each of the cell blocks includes a plurality of cells connected in parallel.

Fig. 3 is a diagram for illustrating an SOC difference according to an exemplary embodiment.

Fig. 4 is a diagram illustrating an example of a graph of time-series data on minimum SOHs, the data being subjected to linear regression.

Fig. 5 is a diagram illustrating an example of a graph including a regression curve of a system SOH derived by subtracting a regression line of an SOC difference from a regression curve of a minimum SOH.

Fig. 6 is a flowchart illustrating a flow of a method for calculating a system SOH according to an exemplary embodiment.

Fig. 7 is a flowchart illustrating a flow of an example of an algorithm of change point extraction processing.

Fig. 8A is a graph illustrating a sample group of time-series data on SOC differences.

Fig. 8B is a graph illustrating a sample group of raw data on SOC differences and a sample group of data after smoothing of the SOC differences.

Fig. 8C is a graph obtained by drawing an interval linear regression line based on the data after smoothing of the SOC differences of Fig. 8B.

Fig. 9A is a graph illustrating a sample group of time-series data on SOC differences.

Fig. 9B is a graph illustrating a sample group of raw data on SOC differences and a sample group of data after smoothing of the SOC differences.

Fig. 9C is a graph obtained by drawing an interval linear regression line based on data after filtering the SOC differences in Fig. 9B.

Fig. 10A is a graph illustrating a sample group of time-series data on minimum SOHs and a linear regression curve based on the sample group of the minimum SOHs.

Fig. 10B is a graph illustrating a regression curve of a system SOH according to an exemplary embodiment.

Fig. 11A is a graph illustrating a sample group of time-series data on minimum SOHs and a linear regression curve based on the sample group of the minimum SOHs.

Fig. 11B is a graph illustrating a regression curve of a system SOH according to an exemplary embodiment.

## DESCRIPTION OF EMBODIMENT

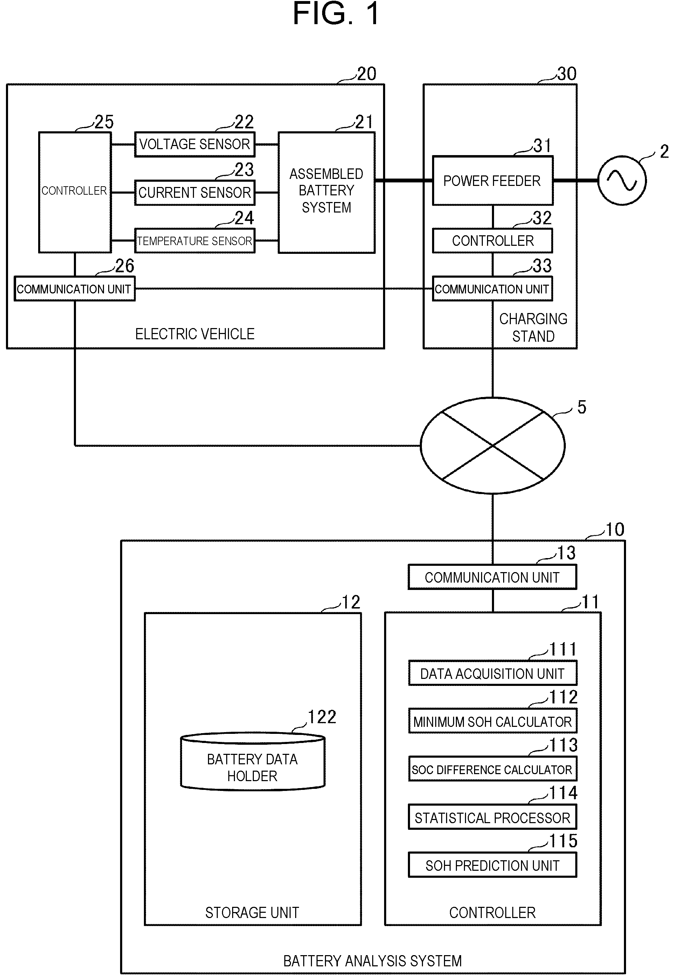

Fig. 1 is a diagram for illustrating battery analysis system 10 according to an exemplary embodiment. Battery analysis system 10 estimates a SOH of assembled battery system 21 included in a battery pack mounted on electric vehicle 20. Battery analysis system 10 can also predict future SOH transition of assembled battery system 21, and can also provide a guideline of time of replacement of the battery pack including assembled battery system 21 to a user.

For example, battery analysis system 10 may be constructed on an own server installed in an own facility or a data center of a company that provides an analysis service of a battery pack mounted on electric vehicle 20. Battery analysis system 10 also may be constructed on a cloud server used based on a cloud service. Battery analysis system 10 also may be constructed on a plurality of servers dispersedly installed in a plurality of bases (data center, own facility). The plurality of servers may be a combination of a plurality of own servers, a combination of a plurality of cloud servers, or a combination of own servers and cloud servers.

Assembled battery system 21 included in the battery pack mounted on electric vehicle 20 supplies electric power to a driving motor (not illustrated). Assembled battery system 21 includes a plurality of cells connected in series or a plurality of cell blocks connected in series.

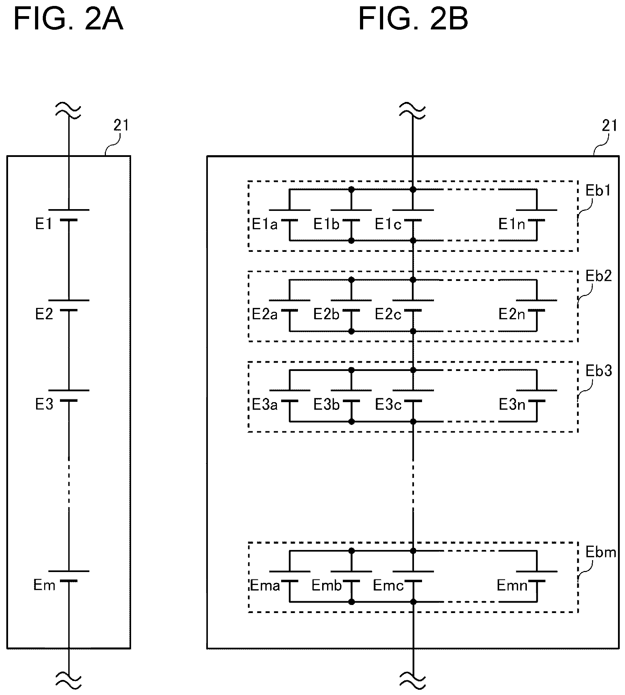

Figs. 2A and 2B are each a diagram illustrating a configuration example of assembled battery system 21. Assembled battery system 21 illustrated in Fig. 2A includes a plurality of cells E1 to Em connected in series. Assembled battery system 21 illustrated in Fig. 2B includes a plurality of cell blocks Eb1 to Ebm connected in series. Each of cell blocks Eb1 to Ebm includes a plurality of cells E1a to E1n, to Ema to Emn, connected in parallel.

Available examples of the cell include a lithium ion battery cell, a nickel metal hydride battery cell, and a lead battery cell. Hereinafter, the present description assumes an example of use of lithium ion battery cells (nominal voltage: 3.6 V to 3.7 V). The number of cells or cell blocks in series is determined in accordance with voltage of the driving motor.

Voltage sensor 22 detects a voltage across each of the cells connected in series or the cell blocks connected in series. The plurality of cells connected in series or the plurality of cell blocks connected in series is connected to a shunt resistor in series. Current sensor 23 detects a current flowing through the cells connected in series or the cell blocks connected in series based on a voltage across the shunt resistor. Instead of the shunt resistor, a Hall element may be used. A plurality of temperature sensors 24 is installed in the battery pack including assembled battery system 21. For example, a thermistor can be used as temperature sensor 24. One temperature sensor 24 may be provided per six to eight cells or per one cell block, for example.

Controller 25 includes a battery management unit (BMU) and an electronic control unit (ECU) that are coordinated with each other. The BMU estimates the SOC by a combination of an open circuit voltage (OCV) method and a current integration method. The OCV method is configured to estimate the SOC based on the OCV of a measured cell and an SOC-OCV curve of the cell. The SOC-OCV curve of the cell is created in advance based on a characteristic test by a battery manufacturer, and is registered in the BMU at the time of shipment.

The current integration method is configured to estimate the SOC based on the OCV at the start of charging and discharging of a cell and an integrated value of a measured current. The current integration method causes a measurement error of the current to accumulate as charging and discharging time increases. Thus, the SOC estimated by the current integration method and the SOC estimated by the OCV method are preferably used by using a weighted average thereof.

The BMU periodically (e.g., an interval of 10 seconds) transmits battery data including voltages, currents, temperatures, and SOCs of a plurality of cells or cell blocks to the ECU through an in-vehicle network, so that the ECU samples the battery data in time series. For example, a controller area network (CAN) or a local interconnect network (LIN) can be used as the in-vehicle network.

Communication unit 26 has a function of performing communication signal processing with communication unit 33 of charging stand 30, and a function of performing wireless signal processing for connection to network 5. Communication unit 26 can access network 5 using a mobile telephone network (cellular network), a wireless LAN, a vehicle to infrastructure (V2I), a vehicle to vehicle (V2V), an electronic toll collection system (ETC system), or dedicated short range communications (DSRC), for example.

Network 5 is a general term for communication paths such as the Internet, a dedicated line, and a virtual private network (VPN), and a communication medium and a protocol thereof are not limited. Available examples of the communication medium include a mobile phone network, a wireless LAN, a wired LAN, an optical fiber network, an ADSL network, and a CATV network. Available examples of the communication protocol include transmission control protocol (TCP)/internet protocol (IP), user datagram protocol (UDP)/IP, and Ethernet (registered trademark).

The ECU may transmit sampled battery data to battery analysis system 10 each time, or may store the sampled battery data in an internal memory and collectively transmit the battery data stored in the memory to battery analysis system 10 at predetermined timing. While electric vehicle 20 and charging stand 30 are connected by a charging cable, the ECU may transmit the battery data stored in the memory to battery analysis system 10 via charging stand 30.

When electric vehicle 20 is connected to charging stand 30 by the charging cable, assembled battery system 21 in electric vehicle 20 can be charged from the outside. Charging stand 30 is connected to commercial power system 2 and charges assembled battery system 21.

In general, AC is used for normal charging, and DC is used for quick charging. For charging with AC (e.g., single-phase 100/200V), a charger (not illustrated) in electric vehicle 20 controls a charging voltage or a charging current. For charging with DC, power feeder 31 of charging stand 30 controls a charging voltage or a charging current. Power feeder 31 includes a rectifier circuit, a filter, and a DC/DC converter to generate DC power by rectifying AC power supplied from commercial power system 2 by full-wave rectification with the rectifier circuit and smoothing the AC power with the filter. The DC/DC converter controls a voltage or a current of the generated DC power.

Available examples of quick charging standards include CHAdeMO (registered trademark), ChaoJi, and GB/T, and combined charging system (Combo). The CHAdeMO, the ChaoJi, and the GB/T each use a CAN as a communication system. The Combo uses power line communication (PLC) as a communication system.

The charging cable using the CAN system includes a communication line in addition to a power line. When electric vehicle 20 and charging stand 30 are connected by the charging cable, controller 25 of electric vehicle 20 establishes a communication channel with controller 32 of charging stand 30. The charging cable using the PLC system transmits a communication signal while superimposing the signal on the power line.

Communication unit 33 of charging stand 30 has a function of performing communication signal processing with communication unit 26 of electric vehicle 20 and a function of performing signal processing for connection to network 5. Communication unit 33 can access network 5 using a wired LAN, a wireless LAN, or a mobile phone network, for example.

Battery analysis system 10 includes controller 11, storage unit 12, and communication unit 13. Communication unit 13 is a communication interface (e.g. NIC: Network Interface Card) for connection to network 5 in a wired or wireless manner.

Controller 11 includes data acquisition unit 111, minimum SOH calculator 112, SOC difference calculator 113, statistical processor 114, and SOH prediction unit 115. Functions of controller 11 can be achieved by cooperation of a hardware resource and a software resource, or by the hardware resource alone. Available examples of the hardware resource include a CPU, a ROM, a RAM, a graphics processing unit (GPU), an application specific integrated circuit (ASIC), a field programmable gate array (FPGA), and other LSI circuits. Available examples of the software resource include a program, such as an operating system or an application.

Storage unit 12 includes a non-volatile recording medium such as an HDD or an SSD, and stores various kinds of data. Storage unit 12 includes battery data holder 121. Data acquisition unit 111 acquires battery data from electric vehicle 20 or charging stand 30, and accumulates the acquired battery data in battery data holder 121. The program may be recorded in a recording medium. When this recording medium is used, the program can be installed in the computer, for example. Here, the recording medium on which the program is recorded may be a non-transitory recording medium. Although the non-transitory recording medium is not particularly limited, it may be a recording medium such as a CD-ROM, for example.

Minimum SOH calculator 112 calculates an SOH of each of a plurality of cells or cell blocks included in assembled battery system 21. For example, minimum SOH calculator 112 calculates a difference (depth of discharge (DOD)) between an SOC corresponding to an OCV at a start of charging and an SOC corresponding to an OCV at an end of the charging, and calculates current integration value $\Sigma I$ during the charging.

Minimum SOH calculator 112 estimates a full charge capacity (FCC) based on a depth of discharge DOD and current integrated value $\Sigma I$ as expressed below (Expression 1). Minimum SOH calculator 112 estimates an SOH based on the estimated FCC and an initial FCC as expressed below (Expression 2). The SOH is defined as a ratio of a current FCC to the initial FCC, and a lower value (closer to 0%) indicates that degradation has progressed more.

$$FCC = \Sigma I / DOD \dots \text{(Expression 1)}$$

$$SOH = Current\ FCC / Initial\ FCC \dots \text{(Expression 2)}$$

Minimum SOH calculator 112 specifies an SOH with the largest DOD among SOHs of the plurality of cells or cell blocks included in assembled battery system 21 as a minimum SOH of assembled battery system 21.

In the present exemplary embodiment, an SOH obtained by subtracting an SOH corresponding to an SOC difference of assembled battery system 21 from the minimum SOH is defined as a system SOH (see (Expression 3) below).

$$System\ SOH = min\ SOH - (\Delta SOC \times min\ SOH) \dots \text{(Expression 3)}$$

SOC difference calculator 113 calculates an SOC difference of assembled battery system 21 based on the maximum SOC and the minimum SOC among the SOCs of the plurality of cells or cell blocks included in assembled battery system 21 and the minimum SOH of assembled battery system 21. Specifically, when a cell or a cell block having the minimum SOH (referred to below as a minimum SOH cell) has an SOC of 100%, SOC difference calculator 113 calculates a difference between an SOC of a cell or a cell block having the maximum SOC (referred to below as a maximum SOC cell) and the SOC of the minimum SOH cell, as an upper SOC difference. When the minimum SOH cell has an SOC of 0%, SOC difference calculator 113 calculates a difference between an SOC of a cell or a cell block (referred to below as a minimum SOC cell) having the minimum SOC and an SOC of the minimum SOH cell, as a lower SOC difference. SOC difference calculator 113 sums the upper SOC difference and the lower SOC difference to calculate a SOC difference of assembled battery system 21.

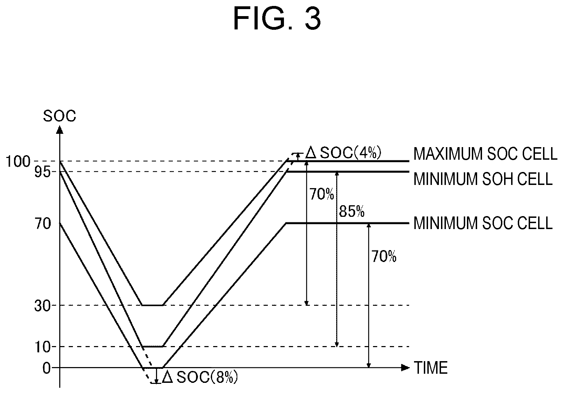

Fig. 3 is a diagram for illustrating an SOC difference according to an exemplary embodiment. For simplification, assembled battery system 21 with three cells connected in series is considered. Fig. 3 illustrates a cell with the first SOC transition from above has a DOD of 70%, a cell with the second SOC transition from above has a DOD of 85%, and a cell with the third SOC transition from above has a DOD of 70%, so that the cell with the second SOC transition from above is the minimum SOH cell. Then, the cell with the first SOC transition is the maximum SOC cell, and the cell with the third SOC transition is the minimum SOC cell.

When the SOC of the minimum SOC cell reaches 0% after discharging starts, the discharging stops. In the present exemplary embodiment, the SOC transition of the minimum SOH cell and the SOC transition of the minimum SOH cell are extended downward, and a SOC difference between a SOC of the minimum SOH cell and a SOC of the minimum SOH cell when the SOC of the minimum SOH cell reaches 0% is calculated as the lower SOC difference. Fig. 3 illustrates an example in which the lower SOC difference is 8%. In a simple way, a SOC difference between a SOC of the minimum SOH cell and a SOC of the minimum SOC cell at the time when the discharging stops may be set as the lower SOC difference.

When the SOC of the maximum SOC cell reaches 100% after charging starts, the charging stops. In the present exemplary embodiment, the SOC transition of the minimum SOH cell and the SOC transition of the maximum SOH cell are extended upward, and a SOC difference between a SOC of the minimum SOH cell and a SOC of the maximum SOH cell when the SOC of the minimum SOH cell reaches 100% is calculated as the upper SOC difference. Fig. 3 illustrates the example in which the upper SOC difference is 4%. In a simple way, a SOC difference between a SOC of the minimum SOH cell and a SOC of the maximum SOC cell at the time when the charging stops may be set as the upper SOC difference.

Fig. 3 illustrates the example in which the SOC difference is 12%. The system SOH is calculated by substituting 12% into the $\Delta$SOC in (Equation 3) above.

Minimum SOH calculator 112 and SOC difference calculator 113 periodically (e.g., once a day, once a week) calculate the minimum SOH and the SOC difference of each assembled battery system 21, and accumulate the minimum SOH and the SOC difference in battery data holder 121.

When estimating the system SOH of target assembled battery system 21, statistical processor 114 reads out time-series data on minimum SOHs and SOC differences of assembled battery system 21 from battery data holder 121.

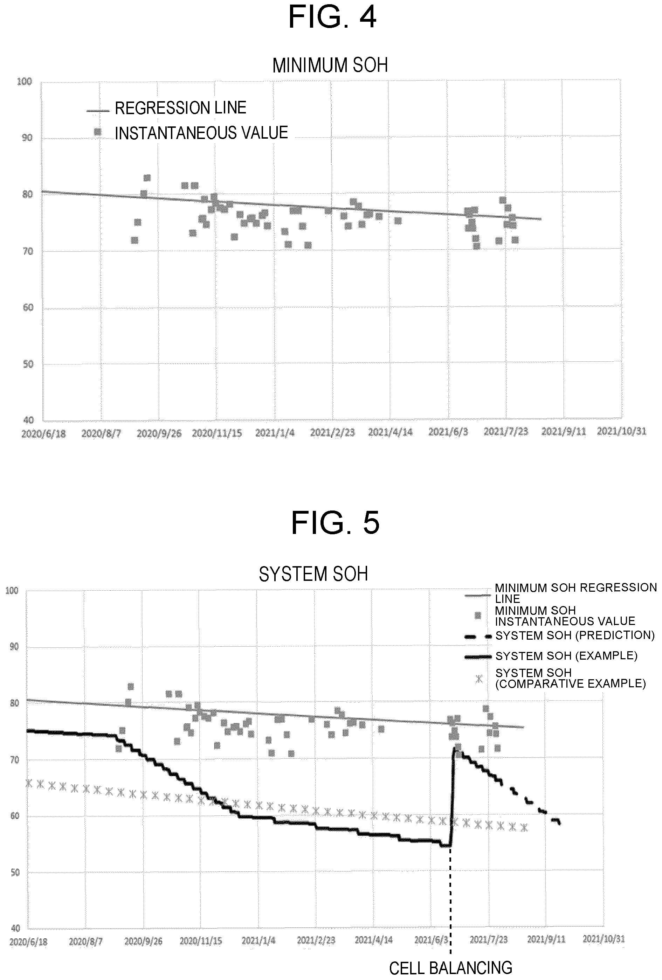

Fig. 4 is a diagram illustrating an example of a graph of time-series data on minimum SOHs, the data being subjected to linear regression. Fig. 4 has a horizontal axis representing a date, and a vertical axis representing SOH [%]. Degradation of a cell is generally known in which the degradation progresses in proportion to a square root of elapsed time (square root law, 0.5 power law), and thus the degradation is obtained by linear regression (linear approximation) using the square root of the elapsed time as an explanatory variable.

Fig. 5 is a diagram illustrating an example of a graph including a regression curve of a system SOH derived by subtracting a regression line of a SOC difference from a regression curve of a minimum SOH. Sample values of the minimum SOHs and the regression curve of a minimum SOH are similar to those in Fig. 4. A regression curve of a system SOH according to Comparative Example is continuously drawn with "*". The regression curve of a system SOH according to Comparative Example is derived by subtracting a regression line of time-series data on SOC differences in the entire interval from a regression curve of a minimum SOH.

The regression curve of a system SOH according to the exemplary embodiment is drawn by a thick line. The regression curve of a system SOH according to the exemplary embodiment is derived by subtracting a regression line for each interval of the time-series data on the SOC differences from the regression curve of a minimum SOH. As described above, the SOC difference greatly changes depending on difference in power consumption, occurrence of a micro-short circuit inside a cell, cell balancing, and the like. These events have characteristics of linearly changing an SOC difference, and a tendency and characteristics of the SOC difference greatly change before and after occurrence of the events. Thus, estimation accuracy of the SOC difference is further improved by dividing data on SOC differences at change points at which the tendency or the characteristics of the SOC difference changes and deriving a linear regression line for each interval.

As shown in (Expression 3) above, the system SOH decreases as the SOC difference increases, and recovers as the SOC difference decreases. As illustrated in Fig. 5, when the SOC difference decreases due to cell balancing, the system SOH recovers.

The regression curve of a system SOH drawn by a thick line includes a dotted line interval that is a prediction line obtained by extending a regression line of a system SOH in the latest interval. The exemplary embodiment enables predicting a future system SOH reflecting the latest state of assembled battery system 21. Hereinafter, a method for calculating a system SOH according to an exemplary embodiment will be described.

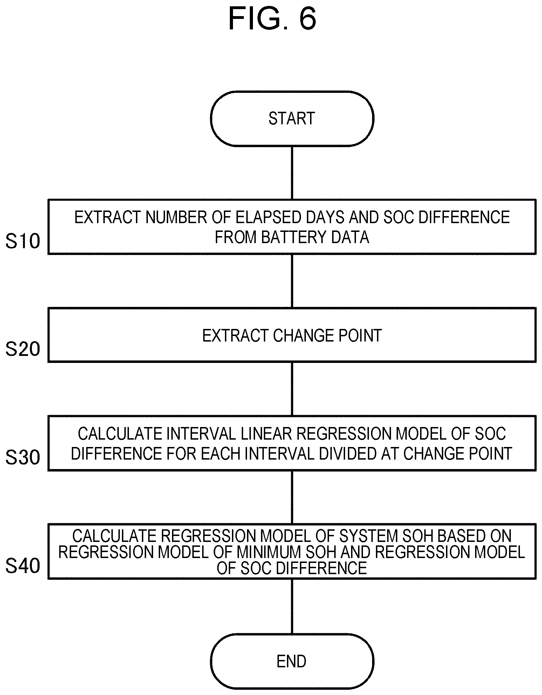

Fig. 6 is a flowchart illustrating a flow of the method for calculating a system SOH according to the exemplary embodiment. Statistical processor 114 extracts elapsed days and SOC differences from battery data on target assembled battery system 21 (S10). For facilitating calculation, a date is converted into the number of days elapsed from an initial date of time-series data.

Statistical processor 114 extracts at least one change point from a sample group of SOC differences (S20). As preprocessing for extracting a change point, statistical processor 114 filters and smooths the time-series data on SOC differences to reduce a variation in the SOC differences. For example, statistical processor 114 calculates a moving average value of five plots of the SOC differences, and replaces a sample value of each SOC difference with an SOC difference having been smoothed.

To shorten calculation time for many plots, statistical processor 114 may extract only an SOC difference during an idle period after charging, or may extract only an SOC difference of a sample having a large weight of SOH estimation.

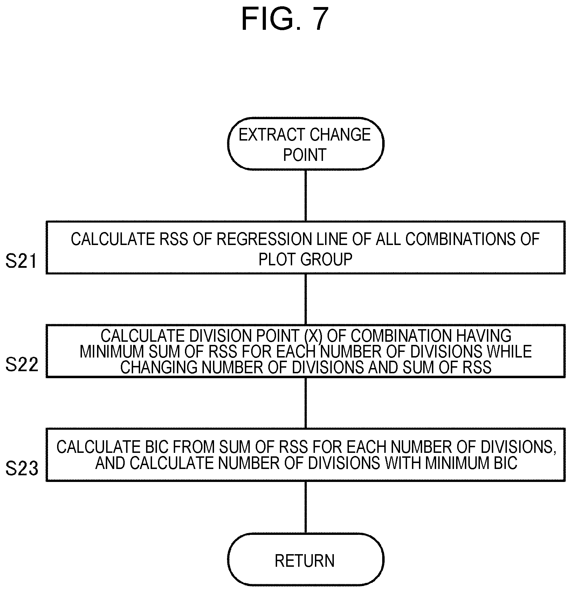

Fig. 7 is a flowchart illustrating a flow of an example of an algorithm of change point extraction processing. Statistical processor 114 calculates residual sum of squares (RSS) of a regression line of each of all combinations of plot groups (S21). The total number of combinations is $\Sigma NCn$ (N is the number of plots of SOC differences, $2 \leq n \leq N$). When the residual sum of squares of each of all the combinations is independently calculated by the least squares method, calculation cost increases, and thus each residual sum of squares may be calculated by using the recursive least squares method.

Statistical processor 114 calculates not only division point (x) of a combination having a minimum sum of residual sums of squares for each number of divisions while changing the number of divisions, but also a sum of the residual sums of squares at that time (S22). Statistical processor 114 calculates Bayesian information criterion (BIC) by applying the sum of the residual sums of squares for each number of divisions to the Gaussian error model of (Expression 4) below.

$$BIC = Nlog_e (RSS/N) + klog_e N \ldots \text{(Expression 4)}$$

where N is the number of plots of SOC differences, RSS is the sum of the residual sums of squares of the respective numbers of divisions, and k is the number of divisions.

Statistical processor 114 specifies the number of divisions with a minimum Bayesian information criterion (S23). Return to Fig. 6. Statistical processor 114 divides the number of elapsed days at positions (change points) with a minimum sum of the residual sums of squares by the calculated number of divisions, and calculates a linear single regression model of an SOC difference for each divided interval (S30).

Statistical processor 114 derives a linear regression function shown in (Expression 5) below for each interval divided at the corresponding change points.

$$f_n(x) = a_n{}^*(x - X_{n-1}) + b \ldots \text{(Expression 5)}$$

$$B = f_{n-1}(X_{n-1})$$

where x is the number of elapsed days, n is an interval, and Xn is an x value at an end of a linear regression function of the interval n.

A constraint condition of intercept b is set to $0 \le b \le (fn [0] + 1)$.

A constraint condition of slope an is set to $-10 \le a_n \le 1$. A negative value indicates a reduction in an SOC difference. The SOC difference may be rapidly reduced by cell balancing, so that a minimum value is set to -10%. A maximum value indicates a maximum SOC difference that increases with elapse of a unit number of days. The maximum SOC difference depends on a model number of a cell and a configuration of an assembled battery system. This example has a maximum enlargement ratio of 1% of the SOC difference.

A constraint condition of last elapsed days Xn in interval n is set to $X_{n-1} \le X_n \le X_{n+1}$.

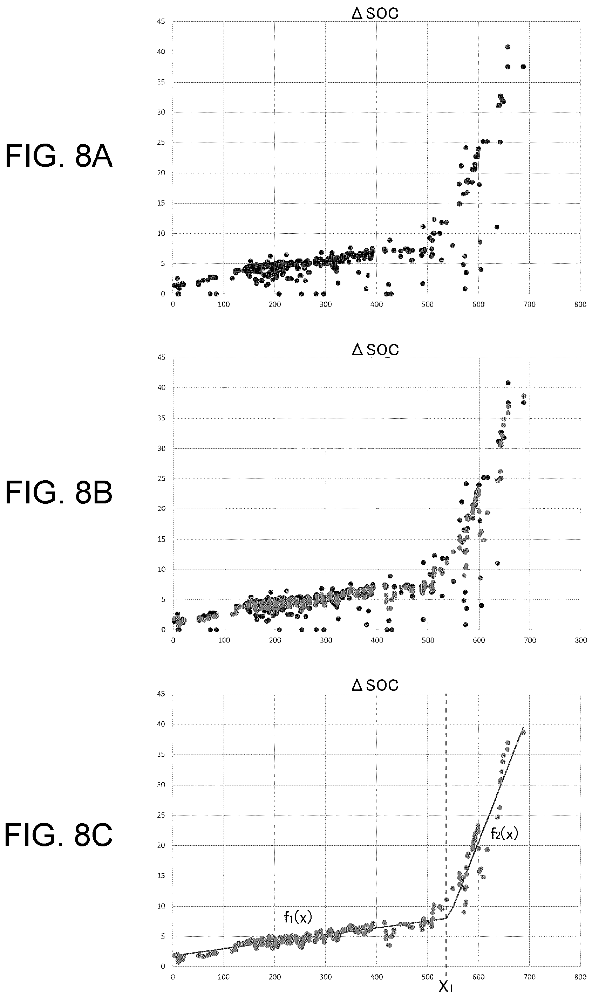

Figs. 8A, 8B, and 8C are each a diagram for illustrating an example of deriving an interval linear regression function of a SOC difference of a cell according to Specific Example 1. Each drawing has a horizontal axis representing elapsed days [days], and a vertical axis representing an SOC difference [%]. Fig. 8A is a graph illustrating a sample group of time-series data on SOC differences. Fig. 8B is a graph illustrating a sample group of raw data on SOC differences and a sample group of data after smoothing of the SOC differences. The raw data on the SOC differences is indicated by a black plot, and the data after smoothing of the SOC differences is indicated by a gray plot. A moving average of five plots is applied as a smoothing filter. Fig. 8C is a graph obtained by drawing an interval linear regression line based on the data after smoothing of the SOC differences of Fig. 8B. The cells according to Specific Example 1 are divided into two intervals. Each interval has a linear regression function expressed by (Expression 6) and (Expression 7) below.

$$f_1(x) = a_1{}^*(x) + b \ldots \text{(Expression 6)}$$

$$f2(x) = a_2{}^*(x - X_1) + f_1(X_1) \ldots \text{(Expression 7)}$$

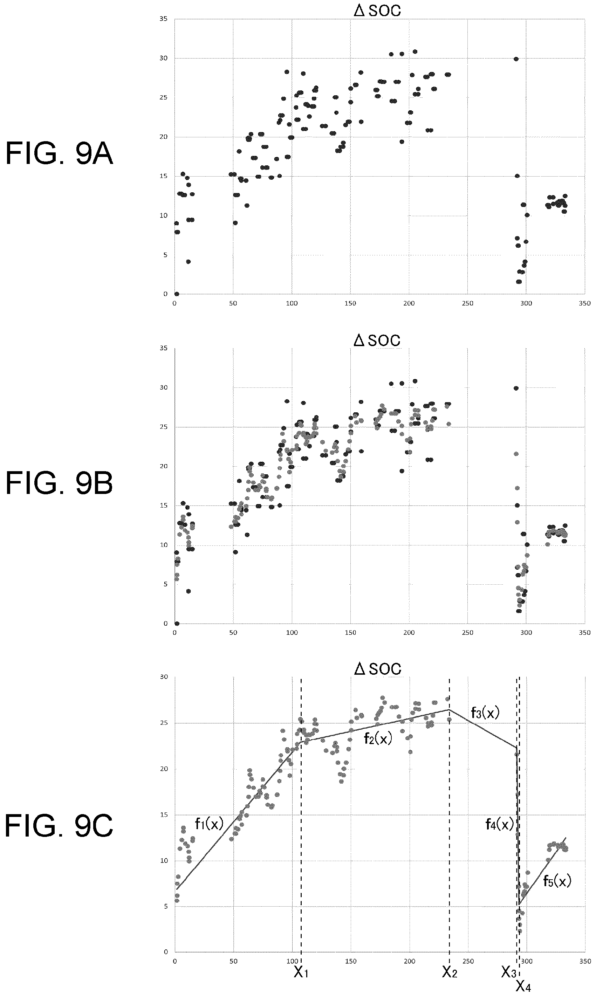

Figs. 9A, 9B, and 9C are each a diagram for illustrating an example of deriving an interval linear regression function of a SOC difference of a cell according to Specific Example 2. Each drawing has a horizontal axis representing elapsed days [days], and a vertical axis representing an SOC difference [%]. Fig. 9A is a graph illustrating a sample group of time-series data on SOC differences. Fig. 9B is a graph illustrating a sample group of raw data on SOC differences and a sample group of data after smoothing of the SOC differences. The raw data on the SOC differences is indicated by a black plot, and the data after smoothing of the SOC differences is indicated by a gray plot. A moving average of five plots is applied as a filter. Fig. 9C is a graph obtained by drawing an interval linear regression line based on data after filtering the SOC differences in Fig. 9B. The cells according to Specific Example 2 are divided into five intervals.

Return to Fig. 6. Statistical processor 114 reads out a sample group of minimum SOHs from battery data on target assembled battery system 21 and calculates a regression model. As described above, degradation of a cell is known in which the degradation progresses in proportion to a square root of elapsed time (square root law, 0.5 power law). In the present exemplary embodiment, statistical processor 114 calculates a linear regression model of the number of elapsed days raised to the power of 0.5 shown in (Expression 8) below.

$$\text{Minimum SOH} = w_0 + w_1\sqrt{t} \ldots \text{(Expression 8)}$$

where $w_0$ is an initial value, $w_1$ is a degradation coefficient, and t is the number of elapsed days.

Initial value w0 is common and is usually set in a range from 1.0 to 1.1 inclusive. When actual initial capacity coincides with a nominal value, $w_0$ is set to 1.0. When the nominal value is set to a minimum guaranteed amount and is set lower than the actual initial capacity, $w_0$ is set to a value greater than 1.0.

Depending on a model number of a cell, a linear regression model using an explanatory variable raised to another power, such as the number of elapsed days raised to the power of 0.4, the power of 0.6, or the power of 1, may be used.

Statistical processor 114 calculates a regression model of a system SOH based on a linear regression model of a minimum SOH and a linear regression model for each interval (S40). Specifically, statistical processor 114 multiplies the linear regression model of a minimum SOH by an interval linear regression model, and converts an influence degree of an SOC difference of assembled battery system 21 on a system SOH into an SOH based on a minimum SOH cell, as shown in (Expression 3) above. At that time, statistical processor 114 linearly interpolates between a point of a SOH of 100% and a head point of the calculated interval linear regression model. The SOC difference at the point of a SOH of 100% of the interpolation straight line is set to 0%. Statistical processor 114 calculates a regression model of a system SOH by subtracting the regression model indicating the influence degree of an SOC difference on a system SOH from the linear regression model of a minimum SOH.

SOH prediction unit 115 predicts a system SOH at a specific future time point based on the regression model of a system SOH. The SOC difference has a minimum value of 0%.

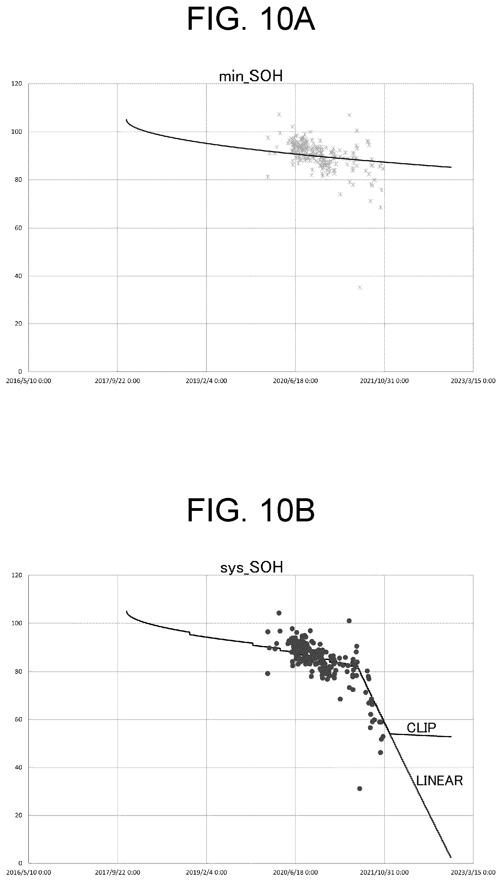

Figs. 10A and 10B are diagrams respectively for calculation examples of a regression model of a minimum SOH of a cell and a regression model of a system SOH according to Specific Example 1. Fig. 4 has a horizontal axis representing a date, and a vertical axis representing SOH [%]. Fig. 10A is a graph illustrating a sample group of time-series data on minimum SOHs and a linear regression curve based on the sample group of the minimum SOHs.

Fig. 10B is a graph illustrating a regression curve of a system SOH according to an exemplary embodiment. The regression curve of a system SOH illustrated in Fig. 10B is generated based on the linear regression model of a minimum SOH and the linear regression model for each interval. The graph also includes a data group of the system SOHs calculated by (Expression 3) above based on data on the minimum SOH and the SOC difference of each date.

As the prediction line extended in the future direction from the regression curve of a system SOH, a line (LINEAR) obtained by directly extending the regression curve in the latest interval according to the regression model may be used, or a line (CLIP) clipped on the way may be used. A clip point may be a time point at which a predetermined period elapses from a time point at which a sample value of the last system SOH exists, or may be a point at which the SOH value decreases by a predetermined value from a sample value (SOH value) of the last system SOH.

The SOC difference from the clip point is set to zero. Thus, a prediction model of a system SOH coincides with a prediction model of a minimum SOH from the clip point. Clipping the SOC difference when the prediction period exceeds the predetermined period enables generating a prediction model in consideration of possibility of change to a new tendency of the SOC difference by limiting a period in which a current tendency of the SOC difference is predicted to continue.

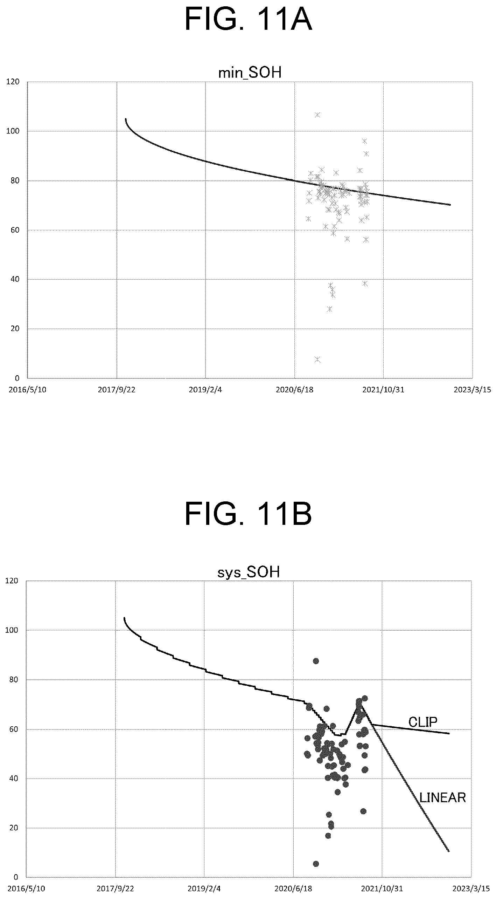

Figs. 11A and 10B are diagrams respectively for calculation examples of a regression model of a minimum SOH of a cell and a regression model of a system SOH according to Specific Example 2. Fig. 4 has a horizontal axis representing a date, and a vertical axis representing SOH [%]. Fig. 11A is a graph illustrating a sample group of time-series data on minimum SOHs and a linear regression curve based on the sample group of the minimum SOHs.

Fig. 11B is a graph illustrating a regression curve of a system SOH according to an exemplary embodiment. The regression curve of a system SOH illustrated in Fig. 11B is generated based on the linear regression model of a minimum SOH and the linear regression model for each interval. As the prediction line extended in the future direction from the regression curve of a system SOH, a line (LINEAR) obtained by directly extending the regression curve in the latest interval according to the regression model may be used, or a line (CLIP) clipped on the way may be used.

As described above, the present exemplary embodiment enables not only the current system SOH to be estimated with high accuracy but also the future system SOH to be predicted with high accuracy by linearly regressing a SOC difference among a plurality of single cells or cell blocks constituting assembled battery system 21 for each interval. Linearly regressing the SOC difference for each interval enables modeling a behavior change of the SOC difference with high accuracy, the behavior change being caused by cell balance collapse, cell balance recovery by equalization processing, and occurrence of internal short circuit, for example.

The present disclosure has been described above based on the exemplary embodiment. It is to be understood by those skilled in the art that the exemplary embodiment is merely an example, that various modifications can be made by combining each component and each processing process of the exemplary embodiment, and that such modifications are also within the scope of the present disclosure.

In the exemplary embodiment above, statistical processor 114 calculates a single regression model for each interval with elapsed time as an explanatory variable and the SOC difference as an objective variable. In a modification, statistical processor 114 may calculate a multiple regression model for each interval with elapsed time, and a temperature difference between a maximum temperature and a minimum temperature in a battery pack including assembled battery system 21, as explanatory variables and the SOC difference as an objective variable. The SOC difference is also affected by a variation in temperature in the battery pack. The SOC difference tends to increase as the variation in temperature in the battery pack increases. In the present modification, the SOC difference can be modeled with higher accuracy in consideration of the variation in temperature in the battery pack.

When assembled battery system 21 includes many series connections, a maximum voltage cell and a minimum voltage cell may be simply specified from a plurality of cells or cell blocks constituting assembled battery system 21, and a minimum SOH and an SOC difference may be calculated assuming that the system is a two-shift system. This way enables the SOC difference between the maximum voltage cell and the minimum voltage cell to be directly used for the ΔSOC in (Expression 3). This modification only requires the maximum voltage and the minimum voltage of the plurality of cells or cell blocks to be included as voltage data in battery data to be transmitted from electric vehicle 20 to battery analysis system 10, and thus the amount of data can be reduced.

When battery data including voltage data on all cells connected in series is acquired by battery analysis system 10, minimum SOH calculator 112 and SOC difference calculator 113 may extract only battery data on a maximum voltage cell and a minimum voltage cell from the battery data on the plurality of cells or cell blocks to calculate a minimum SOH and an SOC difference. This way enables the amount of calculation to be reduced.

The algorithm of change point extraction illustrated in Fig. 7 is an example, and thus another algorithm of change point extraction may be used. Alternatively, a person in charge of analysis may visually separate an interval of time-series data on SOC differences.

In the exemplary embodiment above, a four-wheeled electric vehicle is assumed as electric vehicle 20. In this regard, an electric motorcycle (electric scooter), an electric bicycle, or an electric kick scooter may be used. Examples of the electric vehicle include not only full-standard electric vehicles but also low-speed electric vehicles such as a golf cart and a land car. An apparatus equipped with assembled battery system 21 is not limited to electric vehicle 20. Examples of the apparatus equipped with assembled battery system 21 include an electric ship, a railway vehicle, an electric moving body such as a multi-copter (drone), a stationary power storage system, and a consumer electronic device (smartphone, notebook PC, etc.).

The exemplary embodiment may be defined by items below.

[Item 1]

Battery analysis system (10) including:

data acquisition unit (111) configured to acquire battery data including at least voltage and current of each of a plurality of cells (E1 to Em) connected in series and included in assembled battery system (21), or of each of a plurality of cell blocks (Eb1 to Ebm) each including a plurality of cells connected in parallel, the plurality of cell blocks being connected in series and included in assembled battery system (21);

minimum SOH (State Of Health) calculator (112) configured to calculate a minimum SOH among SOHs of the plurality of cells (E1 to Em) or the plurality of cell blocks (Eb1 to Ebm) included in assembled battery system (21) based on the battery data;

SOC (State Of Charge) difference calculator (113) configured to calculate an SOC difference based on the battery data, the SOC difference being calculated based on a maximum SOC and a minimum SOC among SOCs of the plurality of cells (E1 to Em) or the plurality of cell blocks (Eb1 to Ebm) and the minimum SOH of assembled battery system (21), based on at least the voltage of each of the plurality of cells (E1 to Em) or each of the plurality of cell blocks (Eb1 to Ebm) included in assembled battery system (21); and

statistical processor (114) configured to perform steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of assembled battery system (21) based on the regression model of the minimum SOH and the regression model of the SOC difference for each of the intervals.

This configuration enables an SOH of assembled battery system (21) to be estimated with high accuracy.

[Item 2]

Battery analysis system (10) according to Item 1, further including SOH prediction unit (115) that predicts an SOH of assembled battery system (21) at a specific future time point based on the regression model of the SOH of assembled battery system (21).

This configuration enables a future SOH of assembled battery system (21) to be predicted with high accuracy.

[Item 3]

Battery analysis system (10) according to Item 1, in which statistical processor (114) calculates a single regression model for each of the intervals with elapsed time as an explanatory variable and the SOC difference as an objective variable.
This configuration enables modeling behavior of the SOC difference with high accuracy.

[Item 4]

Battery analysis system (10) according to Item 1, in which

data acquisition unit (111) acquires battery data including voltage, current, and temperature of each of the cells (E1 to Em) or each of the cell blocks (Eb1 to Ebm), and
statistical processor (114) calculates a multiple regression model for each of the intervals using elapsed time and a temperature difference between a maximum temperature and a minimum temperature in a battery pack including assembled battery system (21) as an explanatory variable, and using the SOC difference as an objective variable.

This configuration enables modeling the behavior of the SOC difference with higher accuracy.

[Item 5]

Battery analysis system (10) according to any one of Items 1 to 4, in which SOC difference calculator (113) calculates an SOC difference of each sample by summing an SOC difference between a first SOC of a cell (E1 to Em) or a cell block (Eb1 to Ebm) with the minimum SOH and a second SOC of a cell (E1 to Em) or a cell block (Eb1 to Ebm) with a maximum SOC when the first SOC is 100, and an SOC difference between a third SOC of the cell (E1 to Em) or the cell block (Eb1 to Ebm) with the minimum SOH and a fourth SOC of a cell (E1 to Em) or a cell block (Eb1 to Ebm) with a minimum SOC when the third SOC is 0.
This configuration enables precisely defining an SOC difference of assembled battery system (21), the SOC difference affecting the SOH of assembled battery system (21).

[Item 6]

Battery analysis system (10) according to any one of Items 1 to 4, in which

minimum SOH calculator (112) calculates a minimum SOH from two cells or two cell blocks with corresponding one of a maximum voltage and a minimum voltage among the plurality of cells (E1 to Em) or cell blocks (Eb1 to Ebm) included in assembled battery system (21), and
SOC difference calculator (113) calculates an SOC difference based on SOCs of the two respective cells or the two respective cell blocks and the minimum SOH of assembled battery system (21).

This configuration enables reducing the amount of data or the amount of calculation.

[Item 7]

A battery analysis method including the steps of:

acquiring battery data including at least voltage and current of each of a plurality of cells (E1 to Em) connected in series and included in assembled battery system (21), or of each of a plurality of cell blocks (Eb1 to Ebm) each including a plurality of cells connected in parallel, the plurality of cell blocks being connected in series and included in assembled battery system (21);
calculating a minimum state of health (SOH) among SOHs of the plurality of cells (E1 to Em) or the plurality of cell blocks (Eb1 to Ebm) included in assembled battery system (21) based on the battery data;
calculating a state of charge (SOC) difference based on the battery data, the SOC difference being calculated based on a maximum SOC and a minimum SOC among SOCs of the plurality of cells (E1 to Em) or the plurality of cell blocks (Eb1 to Ebm) and the minimum SOH of assembled battery system (21), based on at least the voltage of each of the plurality of cells (E1 to Em) or each of the plurality of cell blocks (Eb1 to Ebm) included in assembled battery system (21); and
performing steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of assembled battery system (21) based on the regression model of the minimum SOH and the regression model of the SOC difference for each of the intervals.

This configuration enables an SOH of assembled battery system (21) to be estimated with high accuracy.

[Item 8]

A battery analysis program that causes a computer to perform types of processing below:

processing of acquiring battery data including at least voltage and current of each of a plurality of cells (E1 to Em) connected in series and included in assembled battery system (21), or of each of a plurality of cell blocks (Eb1 to Ebm) each including a plurality of cells connected in parallel, the plurality of cell blocks being connected in series and included in assembled battery system (21);
processing of calculating a minimum state of health (SOH) among SOHs of the plurality of cells (E1 to Em) or the plurality of cell blocks (Eb1 to Ebm) included in assembled battery system (21) based on the battery data;
processing of calculating a state of charge (SOC) difference based on the battery data, the SOC difference being calculated based on a maximum SOC and a minimum SOC among SOCs of the plurality of cells (E1 to Em) or the plurality of cell blocks (Eb1 to Ebm) and the minimum SOH of assembled battery system (21), based on at least the voltage of each of the plurality of cells (E1 to Em) or each of the plurality of cell blocks (Eb1 to Ebm) included in assembled battery system (21); and
processing of performing steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of assembled battery system (21) based on the regression model of the minimum SOH and the regression model of the SOC difference for each of the intervals.

This configuration enables an SOH of assembled battery system (21) to be estimated with high accuracy.

REFERENCE MARKS IN THE DRAWINGS

| 2 | commercial power system |
| 5 | network |
| 10 | battery analysis system |
| 11 | controller |
| 12 | storage unit |
| 13 | communication unit |
| 20 | electric vehicle |
| 21 | assembled battery system |
| 22 | voltage sensor |
| 23 | current sensor |
| 24 | temperature sensor |
| 25 | controller |
| 26 | communication unit |
| 30 | charging stand |
| 31 | power feeder |
| 32 | controller |
| 33 | communication unit |
| 111 | data acquisition unit |
| 112 | minimum SOH calculator |
| 113 | SOC difference calculator |
| 114 | statistical processor |
| 115 | SOH prediction unit |
| 121 | battery data holder |

**Claims**

1. A battery analysis system comprising:

   a data acquisition unit configured to acquire at least one set of battery data including at least voltage and current of each of a plurality of cells connected in series and included in an assembled battery system, or of each of a plurality of cell blocks each including a plurality of cells connected in parallel, the plurality of cell blocks being connected in series and included in the assembled battery system;

   a minimum state of health (SOH) calculator configured to calculate a minimum SOH among SOHs of the plurality of cells or the plurality of cell blocks included in the assembled battery system based on the at least one set of battery data;

   a state of charge (SOC) difference calculator configured to calculate an SOC difference based on the at least one set of battery data, the SOC difference being calculated based on a maximum SOC and a minimum SOC among SOCs of the plurality of cells or the plurality of cell blocks and the minimum SOH of the assembled battery system, based on at least the voltage of each of the plurality of cells or each of the plurality of cell blocks included in the assembled battery system; and

   a statistical processor configured to perform steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of the assembled battery system based on the regression model of the minimum SOH and the regression model of the SOC difference for each of the intervals.

2. The battery analysis system according to Claim 1, further comprising an SOH prediction unit that predicts an SOH of the assembled battery system at a specific future time point based on the regression model of the SOH of the assembled battery system.

3. The battery analysis system according to Claim 1, wherein the statistical processor calculates a single regression model for each of the intervals with elapsed time as an explanatory variable and the SOC difference as an objective variable.

4. The battery analysis system according to Claim 1, wherein

   the data acquisition unit acquires battery data including voltage, current, and temperature of each of the cells or each of the cell blocks, and

   the statistical processor calculates a multiple regression model for each of the intervals using elapsed time and a temperature difference between a maximum temperature and a minimum temperature in a battery pack including the assembled battery system as an explanatory variable, and using the SOC difference as an objective variable.

5. The battery analysis system according to any one of Claims 1 to 4, wherein the SOC difference calculator calculates an SOC difference of each sample by summing an SOC difference between a first SOC of a cell or a cell block with the minimum SOH and a second SOC of a cell or a cell block with a maximum SOC when the first SOC is 100, and an SOC difference between a third SOC of the cell or the cell block with the minimum SOH and a fourth SOC of a cell or a cell block with a minimum SOC when the third SOC is 0.

6. The battery analysis system according to any one of Claims 1 to 4, wherein

   the minimum SOH calculator calculates a minimum SOH from two cells or two cell blocks with corresponding one of a maximum voltage and a minimum voltage among the plurality of cells or cell blocks included in the assembled battery system, and

   the SOC difference calculator calculates an SOC difference based on SOCs of the two respective cells or the two respective cell blocks and the minimum SOH of the assembled battery system.

7. A battery analysis method comprising the steps of:

   acquiring battery data including at least voltage and current of each of a plurality of cells connected in series and included in an assembled battery system, or of each of a plurality of cell blocks each including a plurality of cells connected in parallel, the plurality of cell blocks being connected in series and included in the assembled battery system;

calculating a minimum state of health (SOH) among SOHs of the plurality of cells or the plurality of cell blocks included in the assembled battery system based on the at least one set of battery data;

calculating a state of charge (SOC) difference based on the at least one set of battery data, the SOC difference being calculated based on a maximum SOC and a minimum SOC among SOCs of the plurality of cells or the plurality of cell blocks and the minimum SOH of the assembled battery system, based on at least the voltage of each of the plurality of cells or each of the plurality of cell blocks included in the assembled battery system; and performing steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of the assembled battery system based on the regression model of the minimum SOH and the regression model of the SOC difference for each of the intervals.

8. A battery analysis program that causes a computer to perform types of processing below:

processing of acquiring at least one set of battery data including at least voltage and current of each of a plurality of cells connected in series and included in an assembled battery system, or of each of a plurality of cell blocks each including a plurality of cells connected in parallel, the plurality of cell blocks being connected in series and included in the assembled battery system;

processing of calculating a minimum state of health (SOH) among SOHs of the plurality of cells or the plurality of cell blocks included in the assembled battery system based on the at least one set of battery data;

processing of calculating a state of charge (SOC) difference based on the at least one set of battery data, the SOC difference being calculated based on a maximum SOC and a minimum SOC among SOCs of the plurality of cells or the plurality of cell blocks and the minimum SOH of the assembled battery system, based on at least the voltage of each of the plurality of cells or each of the plurality of cell blocks included in the assembled battery system; and processing of performing steps of: extracting at least one change point from a group of samples of the SOC difference; calculating a regression model of an SOC difference for each of intervals divided by the at least one change point; calculating a regression model of a minimum SOH based on a group of samples of the minimum SOH; and calculating a regression model of an SOH of the assembled battery system based on the regression model of the minimum SOH and the regression model of the SOC difference for each of the intervals.

9. A temporary storage medium in which a battery analysis program is described, the battery analysis program being executed by the computer according to Claim 8.

# FIG. 1

# FIG. 2A

# FIG. 2B

# FIG. 3

# FIG. 4

**MINIMUM SOH**

# FIG. 5

**SYSTEM SOH**

CELL BALANCING

# FIG. 6

```
                    START

S10   EXTRACT NUMBER OF ELAPSED DAYS AND SOC DIFFERENCE
      FROM BATTERY DATA

S20   EXTRACT CHANGE POINT

S30   CALCULATE INTERVAL LINEAR REGRESSION MODEL OF SOC
      DIFFERENCE FOR EACH INTERVAL DIVIDED AT CHANGE POINT

S40   CALCULATE REGRESSION MODEL OF SYSTEM SOH BASED ON
      REGRESSION MODEL OF MINIMUM SOH AND REGRESSION MODEL
      OF SOC DIFFERENCE

                    END
```

# FIG. 7

```
         EXTRACT CHANGE
             POINT
               │
               │
S21  │ CALCULATE RSS OF REGRESSION LINE OF ALL COMBINATIONS OF │
     │                      PLOT GROUP                          │
               │
               │
S22  │ CALCULATE DIVISION POINT (X) OF COMBINATION HAVING       │
     │ MINIMUM SUM OF RSS FOR EACH NUMBER OF DIVISIONS WHILE    │
     │ CHANGING NUMBER OF DIVISIONS AND SUM OF RSS              │
               │
               │
S23  │ CALCULATE BIC FROM SUM OF RSS FOR EACH NUMBER OF DIVISIONS, │
     │ AND CALCULATE NUMBER OF DIVISIONS WITH MINIMUM BIC         │
               │
               │
             RETURN
```

FIG. 8A

ΔSOC

FIG. 8B

ΔSOC

FIG. 8C

ΔSOC

FIG. 9A

FIG. 9B

FIG. 9C

# FIG. 10A

min_SOH

# FIG. 10B

sys_SOH

# FIG. 11A

min_SOH

# FIG. 11B

sys_SOH

## INTERNATIONAL SEARCH REPORT

International application No.

**PCT/JP2023/041323**

| A. | CLASSIFICATION OF SUBJECT MATTER |
|---|---|

*G01R 31/392*(2019.01)i; *G01R 31/367*(2019.01)i; *G01R 31/382*(2019.01)i; *G01R 31/385*(2019.01)i; *G01R 31/387*(2019.01)i; *G01R 31/396*(2019.01)i; *H01M 10/48*(2006.01)i; *H02J 7/00*(2006.01)i

FI: G01R31/392; G01R31/367; G01R31/382; G01R31/385; G01R31/396; G01R31/387; H02J7/00 Y; H01M10/48 P; H01M10/48 301

According to International Patent Classification (IPC) or to both national classification and IPC

| B. | FIELDS SEARCHED |
|---|---|

Minimum documentation searched (classification system followed by classification symbols)

G01R31/392; G01R31/367; G01R31/382; G01R31/385; G01R31/387; G01R31/396; H01M10/48; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 2022/024848 A1 (PANASONIC INTELLECTUAL PROPERTY MANAGEMENT CO., LTD.) 03 February 2022 (2022-02-03) entire text, all drawings | 1-9 |
| A | JP 2022-81951 A (HITACHI, LTD.) 01 June 2022 (2022-06-01) entire text, all drawings | 1-9 |
| A | JP 2014-163875 A (SHIN-KOBE ELECTRIC MACHINERY CO., LTD.) 08 September 2014 (2014-09-08) entire text, all drawings | 1-9 |
| A | WO 2022/091894 A1 (PANASONIC INTELLECTUAL PROPERTY MANAGEMENT CO., LTD.) 05 May 2022 (2022-05-05) paragraphs [0087]-[0092], fig. 10A-10C | 1-9 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **17 January 2024** | **30 January 2024** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (July 2022)

**INTERNATIONAL SEARCH REPORT**
**Information on patent family members**

International application No.

**PCT/JP2023/041323**

| Patent document cited in search report | | | Publication date (day/month/year) | Patent family member(s) | | | Publication date (day/month/year) |
|---|---|---|---|---|---|---|---|
| WO | 2022/024848 | A1 | 03 February 2022 | US | 2023/0266399 | A1 | |
| | | | | entire text, all drawings | | | |
| | | | | EP | 4191733 | A1 | |
| | | | | CN | 116134658 | A | |
| JP | 2022-81951 | A | 01 June 2022 | WO | 2022/107536 | A1 | |
| | | | | entire text, all drawings | | | |
| JP | 2014-163875 | A | 08 September 2014 | (Family: none) | | | |
| WO | 2022/091894 | A1 | 05 May 2022 | EP | 4239291 | A1 | |
| | | | | paragraphs [0087]-[0092], fig. 10A-10C | | | |
| | | | | CN | 116348740 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019113414 A

- WO 17098686 A